# EUROPÄISCHE PATENTSCHRIFT

(11) **EP 3 748 234 B1**
(45) Veröffentlichungstag und Bekanntmachung des Hinweises auf die Patenterteilung: **02.03.2022**
(21) Anmeldenummer: 20173621.2
(22) Anmeldetag: 08.05.2020
(51) Int. Cl.: F24C 7/08, H01H 36/00, G05G 1/10, H01H 9/18, H01H 19/02, H03K 17/97

(54) **BEDIENEINRICHTUNG FÜR EIN ELEKTROGERÄT UND VERFAHREN ZUR BEDIENUNG EINES ELEKTROGERÄTS**
OPERATING DEVICE FOR AN ELECTRICAL DEVICE AND METHOD FOR PRODUCING AN ELECTRICAL DEVICE
DISPOSITIF DE COMMANDE POUR UN APPAREIL ÉLECTRIQUE ET PROCÉDÉ DE FONCTIONNEMENT D'UN APPAREIL ÉLECTRIQUE

(30) Priorität: 03.06.2019 DE 102019208064
(43) Veröffentlichungstag der Anmeldung: 09.12.2020
(73) Patentinhaber: E.G.O. Elektro-Gerätebau GmbH, 75038 Oberderdingen (DE)
(72) Erfinder: Moch, Benedict, 76703 Menzingen (DE); Ose, Lutz, 75447 Sternenfels (DE); Seidler, Christian, 75015 Bretten (DE); Thimm, Wolfgang, 76137 Karlsruhe (DE); Zarcone, Carmelo, 75038 Oberderdingen (DE)
(74) Vertreter: Patentanwälte Ruff, Wilhelm, Beier, Dauster & Partner mbB

(56) Entgegenhaltungen:
- CN-A- 108 646 995
- CN-U- 208 819 534
- DE-A1-102014 016 570

## Beschreibung

Die Erfindung betrifft eine Bedieneinrichtung für ein Elektrogerät sowie ein Verfahren zur Bedienung eines solchen Elektrogeräts. Insbesondere ist das Elektrogerät ein Kochfeld.

Aus der DE 10 2010 010 574 A1 ist allgemein eine Bedieneinrichtung bekannt, die insbesondere für ein Fahrzeug ausgelegt ist. Sie weist an einer Bedienblende ein bewegbares Bedienelement auf, und durch Drehung erfolgt eine Bedienung, insbesondere eine Einstellung.

Aus der EP 797 227 A2 ist eine weitere Bedieneinrichtung bekannt, die für ein Kochfeld ausgelegt ist. Hier kann ein drehbares Bedienelement abgenommen werden, wobei es durch Magnetkraft gehalten ist.

Aus der DE 10 2017 207 388 A1 ist eine nochmals weitere Bedieneinrichtung bekannt, mit der ein Gargerät bedient werden kann. Die Bedieneinrichtung weist ein Bedienelement auf, das von dem Gargerät abgenommen werden kann. Es wird magnetisch gehaltert und kann um eine senkrechte Drehachse gedreht werden. Des Weiteren weist das Bedienelement Lichtquellen oder ein Display als optische Anzeige auf.

Aus der DE 10 2010 050 771 B4 ist ein Kochfeld mit einer Kochfeldplatte aus Glas oder Glaskeramik bekannt, wobei auf die Oberseite dieser Kochfeldplatte eine anorganische Schicht aufgebracht ist, die eine zumindest teilweise nanokristalline Struktur aufweist. Als Basiselement dieser Schicht ist ein Metalloxid der Elemente Hf, Y, Zr oder Ce enthalten. Dadurch kann eine schmutzabweisende oder leicht zu reinigende Oberfläche der Kochfeldplatte erreicht werden. Aus der CN 208 819 534 U ist eine Bedieneinrichtung mit einem Display für eine Anzeige bekannt, die eine Berührfläche aufweisen kann. Unter einer Bedienfläche und dem Display kann an einer Stelle ein Fotosensor angeordnet sein, der durch die Berührfläche einfallendes Licht erfassen soll. Über dem Fotosensor ist an der Unterseite der Berührfläche eine beeinflussbare Schicht als Blende vorgesehen, die beispielsweise als magnetochrome Schicht ausgebildet sein kann. Unterhalb des Fotosensors kann eine Spule angeordnet sein, um die magnetochrome Schicht durchsichtig oder undurchsichtig zu machen, so dass Licht auf den Fotosensor einfällt oder nicht.

Aus der CN 108 646 995 A1 ist eine Bedieneinrichtung zum Einstellen von Bildschirmfarben bekannt, wobei hierfür auch magnetochrome Effekte genutzt werden können. Allerdings beschreibt diese keinerlei bewegbares Bedienelement, es wird eine Berührfläche als Touch Touchscreen genutzt.

Aus der DE 10 2014 016 570 A1 ist es bekannt, eine Fahrzeugtür mit einem Touchscreen zu versehen. An diesem Touchscreen kann in einem ersten Steuer-Anzeigemodus ein Steuerbedienelement für einen ersten Aktor angezeigt werden, und in einem zweiten Steuer-Anzeigemodus ein zweites Steuerbedienelement zum Steuern eines anderen zweiten Aktors. Hier sollen sämtliche Bedienungen über den Touchscreen erfolgen.

### Aufgabe und Lösung

Der Erfindung liegt die Aufgabe zugrunde, eine eingangs genannte Bedieneinrichtung für ein Kochfeld sowie ein Verfahren zur Bedienung eines Kochfelds zu schaffen, mit denen Probleme des Standes der Technik gelöst werden können und es insbesondere möglich ist, eine Leuchtanzeige zu schaffen, die robust und fehlerunanfällig ist sowie einfach in Aufbau, Montage und Betrieb.

Gelöst wird diese Aufgabe durch eine Bedieneinrichtung mit den Merkmalen des Anspruchs 1 sowie durch ein Verfahren mit den Merkmalen des Anspruchs 13. Vorteilhafte sowie bevorzugte Ausgestaltungen der Erfindung sind in den weiteren Ansprüchen enthalten und werden im Folgenden näher erläutert. Dabei werden manche der Merkmale nur für die Bedieneinrichtung oder nur für das Verfahren beschrieben. Sie sollen jedoch unabhängig davon sowohl für die Bedieneinrichtung als auch für das Verfahren selbständig und unabhängig voneinander gelten können. Der Wortlaut der Ansprüche wird durch ausdrückliche Bezugnahme zum Inhalt der Beschreibung gemacht.

Es ist vorgesehen, dass die Bedieneinrichtung für ein Elektrogerät eine Bedienblende sowie eine Halteeinrichtung an der Bedienblende aufweist. Dabei kann die Halteeinrichtung fest bzw. unlösbar an der Bedienblende angeordnet sein. Alternativ kann sie daran befestigt sein bzw. von der Oberseite oder einer Außenseite des Elektrogeräts bzw. der Bedienblende abgenommen werden. Sie kann daran beispielsweise magnetisch gehaltert sein, alternativ durch Verrasten odgl.. An der Halteeinrichtung wiederum ist ein Bedienelement der Bedieneinrichtung gehaltert. Das Bedienelement kann möglicherweise von der Halteeinrichtung abnehmbar ausgebildet sein, beispielsweise aufgeklipst sein, und durch Überwinden einer bestimmten Haltekraft abgenommen werden. Dies ist insbesondere dann von Vorteil, wenn die Halteeinrichtung selbst nicht vom Elektrogerät entfernt werden kann. Alternativ kann das Bedienelement mit der Halteeinrichtung eine Baueinheit bilden und zusammen am Elektrogerät bzw. der Bedienblende befestigt werden oder abgenommen werden. Das Bedienelement ist an der Halteeinrichtung oder relativ zu dieser bewegbar zwischen einer Grund-Stellung und mehreren Bedien-Stellungen. Eine Grund-Stellung kann beispielsweise einen Eingabewert von Null für einen bestimmten Betriebsparameter des Elektrogeräts dar-stellen, beispielsweise eine Leistungsstufe Null im Fall eines Kochfelds als Elektrogerät. Eine Bedienbewegung des Bedienelements ist vorteilhaft eine Drehung, alternativ kann es auch in einem Bogen oder entlang eines geraden Wegs verschoben werden. Schließlich weist die Bedieneinrichtung noch Erkennungsmittel auf, um eine Position und/oder eine Bewegung des Bedienelements zu erkennen. Daraus kann eine Bedienung für das Elektrogerät bewirkt werden. Hierfür gibt es zahlreiche bekannte Möglichkeiten im Stand der Technik, deswegen soll dies nicht im Fokus stehen. Möglich sind Erkennungsmittel in Form eines Magnetfeldsensors, der zusammen mit einem Signalmagneten wirkt. Verwiesen wird auf die EP 797 227 A2.

Das Bedienelement weist mindestens ein Magnet-Element mit einem magnetischen Wirkfeld unter einer Oberseite des Bedienelements auf, alternativ weist die Halteeinrichtung entsprechend mindestens ein Magnet-Element auf. Ein solches Magnet-Element kann einerseits in vorteilhafter Ausgestaltung der Erfindung ein Dauermagnet sein, alternativ kann es ein ferritisches Element sein, das von einem nochmals weiteren Magneten magnetisiert wird bzw. dessen Magnetfeld leitet, wie wenn es ein eigenes magnetisches Wirkfeld wäre. Das Bedienelement weist oberhalb des mindestens einen Magnet-Elements magnetochromes Material auf, welches am Bedienelement, vorteilhaft an einer Oberseite des Bedienelements, sichtbar ist. Somit ist das magnetochrome Material am Bedienelement sichtbar, insbesondere von oben, und kann eine Informationsanzeige oder sonstige Anzeige für eine Bedienperson bilden. Dabei ist das magnetochrome Material zumindest teilweise in der Grund-Stellung und/oder in einer der Bedien-Stellungen des Bedienelements einer Veränderung des Wirkfelds des Magnet-Elements ausgesetzt, wodurch seine optische Erscheinung beeinflusst wird. Somit kann beispielsweise das Magnet-Element bzw. sein magnetisches Wirkfeld näher an das magnetochrome Material heranbewegt werden oder sich weiter davon entfernen, so dass eine Farbänderung oder optische Änderung am magnetochromen Material erfolgt, die von einer Bedienperson als Anzeige bzw. als Informationsanzeige wahrgenommen wird. Alternativ kann sich das Wirkfeld mindestens eines Magnet-Elements relativ zu dem magnetochromen Material bewegen und so eine Informationsanzeige am Bedienelement bilden. Um das magnetochrome Material nun durch das vorgenannte Wirkfeld beeinflussen zu können, sind in der Halteeinrichtung Mittel zur Beeinflussung vorgesehen. Diese Mittel sind derart ausgebildet, dass abhängig von einer Bedien-Stellung oder auch einer Grund-Stellung des Bedienelements an der Halteeinrichtung die optische Erscheinung des magnetochromen Materials beeinflusst ist. Diese genannten Mittel setzen also sozusagen eine Bedien-Stellung und vor allem eine Bewegung des Bedienelements in eine Änderung eines magnetisches Felds bzw. Wirkfelds am magnetochromen Material um, was dann eine für die Bedienperson gut erkennbare veränderte Anzeige durch das magnetochrome Material ergibt.

Somit kann eine Bedieneinrichtung geschaffen werden mit einer Informationsanzeige für eine Bedienperson, die ohne zusätzliche Energiezufuhr wie beispielsweise einen Stromanschluss auskommt. Es brauchen auch keine sonstigen Maßnahmen wie Durchleuchten einer Bedienblende von unten vorgesehen zu sein, um Anzeigeeffekte bzw. Leuchteffekte am Bedienelement erzeugen zu können. Eine Bedienblende kann in vorteilhafter Ausgestaltung der Erfindung auch geschlossen und ohne Durchbruch ausgebildet sein, insbesondere auch nicht mit verschlossenem Durchbruch. So kann beispielsweise bei einem Kochfeld als Elektrogerät die Bedienblende eine Kochfeldplatte aus Glaskeramik sein, welche nur mit Schwierigkeiten und großem Aufwand mit Bohrungen oder Durchbrechungen versehen werden könnte. Auch wenn im Inneren im Bedienelement und/oder an der Halteeinrichtung mechanische Einrichtungen vorgesehen sind wie beispielsweise bewegbare Kulissenteile odgl., so kann doch zumindest das Bedienelement nach außen hin geschlossen und ohne Durchbruch ausgebildet sein. So kann es insbesondere auch wasserdicht sein.

In einer Ausgestaltung der Erfindung ist das magnetochrome Material als magnetochrome Folie ausgebildet bzw. liegt in dieser Form vor. Eine solche Folie kann leicht als separates Teil in bereits ausgeschnittener Form an dem Bedienelement angebracht werden, beispielsweise oben auf eine Oberseite oder eine Bedienelementabdeckung aufgelegt und aufgeklebt werden. Alternativ kann eine solche magnetochrome Folie auch unter einer lichtdurchlässigen Bedienelementabdeckung angeordnet werden, beispielsweise eingelegt und angedrückt werden, alternativ angeklebt werden.

In einer Ausgestaltung als Alternative zu einer magnetochromen Folie kann magnetochromes Material über einer Bedienelementabdeckung an der Oberseite des Bedienelements vorgesehen sein. Es kann beispielsweise als eine Art Lack oder Beschichtung aufgebracht werden. Vorteilhaft ist zum Schutz des magnetochromen Materials allgemein eine Bedienelementabdeckung oben am Bedienelement bzw. an seiner Oberseite über dem magnetochromen Material vorgesehen. So kann das magnetochrome Material auch an einer Unterseite dieser Bedienelementabdeckung angeordnet sein, beispielsweise auf diese Unterseite aufgebracht worden sein wie vorstehend beschrieben als Lack oder Beschichtung. Eine solche Bedienelementabdeckung ist vorteilhaft aus hartem bzw. kratzfestem Kunststoff ausgebildet, möglicherweise auch aus Glas. Eine genannte Bedienelementabdeckung kann allgemein einen wesentlichen Bereich der Oberseite des Bedienelements bilden, vorteilhaft mindestens 80% der Oberseite oder mindestens 90%. Sie kann eben oder auch gewölbt ausgebildet sein.

In Ausgestaltung der Erfindung ist das mindestens eine Magnet-Element in dem Bedienelement fest und unbewegbar angeordnet. Dieses Magnet-Element weist dann das ferromagnetische Material auf wie vorgenannt, erzeugt also nicht selbst ein Magnetfeld, sondern kann es nur weiterleiten und möglicherweise etwas formen oder konzentrieren. Dann sind in der Halteeinrichtung oder unter der Bedienblende Magnete angeordnet, die abhängig von einer Position des mindestens einen Magnet-Elements über dem Magneten oder daneben das Magnetfeld darüber und somit das Wirkfeld des Magnet-Elements hin zum magnetochromen Material beeinflussen. Somit wird eine Änderung des Magnetfelds am magnetochromen Material nicht durch das nahe dazu angebrachte Magnet-Element vorgenommen, sondern durch einen nochmals etwas weiter davon entfernt angeordneten Magneten. Dieser Magnet wird dann relativ dazu bewegt, insbesondere durch eine übliche und vorgesehene Bedienbewegung des Bedienelements an der Halteeinrichtung, beispielsweise als Drehung. Dies wird nachfolgend noch im Detail erläutert.

In alternativer Ausgestaltung der Erfindung kann das mindestens eine Magnet-Element in dem Bedienelement bewegbar sein relativ zu dem Bedienelement, und zwar in einer Bewegungsrichtung hin zur Bedienblende oder weg von der Bedienblende. Diese Bewegungsrichtung kann alternativ auch hin oder weg von der Oberseite des Bedienelements bzw. der Bedienelementabdeckung sein. Dann kann das Magnet-Element selbst also seine Position zum magnetochromen Material ändern und damit auch den Einfluss darauf aufgrund seines mit ihm bewegten Wirkfelds. Dies ermöglicht es, das Magnet-Element nicht nur wie vorbeschrieben als ferromagnetisches Teil auszubilden, das ein von einem weiteren Magneten erzeugtes Magnetfeld weiterleitet, sondern das Magnet-Element selbst als Magnet bzw. als Dauermagnet auszubilden. Je nach Bewegung hin zum magnetochromen Material oder davon weg ergibt sich ein unterschiedliches Verhalten des magnetochromen Materials und somit eine Veränderung von dessen Erscheinungsbild, was dann eben die genannte und beabsichtigte Informationsanzeige an der Bedieneinrichtung für eine Bedienperson schafft.

Das Magnet-Element kann an seiner Oberseite eine Form aufweisen, die von einer kreisrunden Form oder einer rechtwinkligen Form abweicht, obwohl dies einfache Formen sind für eine einfache Beeinflussung des magnetochromen Materials. Diese Form an der Oberseite kann eine Symbolform sein, wie sie auf dem Gebiet des Kochens verwendet wird und insbesondere einem Buchstaben oder einer Ziffer entspricht, alternativ einem Piktogramm. Durch eine dermaßen ausgestaltete Oberfläche kann möglicherweise deren Kontur sozusagen im magnetochromen Material wiedergegeben werden. So tritt dort nicht nur eine undefinierte oder beliebige Änderung der optischen Erscheinung auf, sondern es wird tatsächlich etwas dargestellt. In vorteilhafter Ausgestaltung der Erfindung weist die Oberseite des Magnet-Elements aber eine vorgenannte einfache Grundform auf.

Bevorzugt sind allgemein mehrere Magnet-Elemente in der Bedieneinrichtung vorgesehen, insbesondere im Bedienelement. Dies können auch drei bis zehn oder noch mehr Magnet-Elemente sein, beispielsweise entsprechend den Leistungsstufen in einem Kochfeld oder um eine Sieben-Segment-Anzeige darstellen zu können mit weiteren zusätzlichen Informationen. Dabei können mehrere oder alle der Magnet-Elemente gleiche Form aufweisen an ihrer Oberseite, so dass sie dieselbe optische Erscheinung an dem magnetochromen Material hervorrufen. Alternativ können einige Magnet-Elemente auch unterschiedlich ausgebildet sein, beispielsweise für eine genannte Sieben-Segment-Anzeige oder für zusätzliche spezielle Informationsanzeigen.

Besonders bevorzugt sind mehrere Magnet-Elemente der Bedieneinrichtung bewegbar, insbesondere alle Magnet-Elemente bewegbar mit im Wesentlichen derselben Bewegungsrichtung.

Für die bewegbaren Magnet-Elemente kann vorgesehen sein, dass sie in länglichen Kanälen oder Führungen bewegbar angeordnet sind. Diese Kanäle oder Führungen verlaufen entlang der genannten Bewegungsrichtung der Magnet-Elemente bzw. definieren oder bestimmen diese. Vorteilhaft können die Magnet-Elemente dabei im Bedienelement angeordnet bzw. darin bewegbar sein, alternativ an der Halteeinrichtung bzw. derart angeordnet sein, dass sie sich bei der Bedienbewegung des Bedienelements, beispielsweise einem Drehen, nicht mitbewegen bzw. nicht mitdrehen. Die genannten Kanäle oder Führungen sind vorteilhaft so lang wie ein gewünschter Bewegungsweg der Magnet-Elemente ist, möglicherweise 10% bis 30% länger für eine sichere und präzise Führung der Bewegung.

Ist ein Magnet-Element fest und unbewegbar angeordnet, insbesondere in dem Bedienelement, so ist es vorteilhaft ein Ferrit bzw. besteht aus ferromagnetischem Material. Es kann dann über mehrere unterschiedliche Magnete bzw. Dauermagnete hinwegbewegt werden, so dass es jeweils deren Magnetfeld aufnimmt und sozusagen als Wirkfeld damit das magnetochrome Material beeinflusst.

Die Kanäle sind vorteilhaft entsprechend der äußeren Form der Magnet-Elemente ausgebildet, so dass diese dort leichtgängig bewegt werden können und gleichzeitig nicht verkanten oder hängen bleiben.

In vorteilhafter Ausgestaltung der Erfindung ist an der Halteeinrichtung eine Kulisse angeordnet mit Kulissenvorsprüngen. Diese Kulissenvorsprünge sind vorteilhaft an einem Kulissenboden angeordnet oder ausgebildet, der parallel zu der Bedienblende und parallel zu einer Oberseite des Bedienelements sein kann, insbesondere in rechtem Winkel zur Bewegungsrichtung der Magnet-Elemente oder Magnete verläuft. Die Kulissenvorsprünge weisen zu dem mindestens einen zugehörigen Magnet-Element hin, insbesondere nach oben, und sind entlang der Richtung der Bewegung des zugehörigen Magnet-Elements oder Magnets ansteigend mit einer Schräge ausgebildet. Zusätzlich oder alternativ kann deren zugehöriges Magnet-Element unten oder zu dem Kulissenvorsprung hinweisend mit einer Schräge ausgebildet sein. In einfacher und vorteilhafter Ausgestaltung der Erfindung wird durch die Bedienbewegung des Bedienelements eine Relativbewegung zwischen Kulissenvorsprung und zugehörigem Magnet-Element oder Magnet bewirkt, so dass die beiden Teile gegeneinander laufen. Durch die genannte Schräge wird auf an sich bekannte Art und Weise bei dieser Kulisse die Bedienbewegung in eine winklig dazu stehende, vorteilhaft rechtwinklig stehende, Bewegung des Magnet-Elements bzw. Magneten umgewandelt. Damit können diese dann durch die Bedienbewegung gegen den Kulissenvorsprung bewegt oder gedrückt werden, und somit näher zu dem magnetochromen Material oder von diesem wegbewegt werden. Jedenfalls kann sich das Wirkfeld des Magnet-Elements zum magnetochromen Material hin verändern, so dass dieses seine optische Erscheinung ändert.

Für einen genannten Bewegungsweg des Magnet-Elements können eine maximale Höhe, ein maximaler Anstieg der Schräge des Kulissenvorsprungs oder des zugehörigen Magnet-Elements einem Maximum dieses Bewegungswegs entsprechen. So kann durch den Kulissenvorsprung das Magnet-Element genau so weit bewegt werden, wie es beabsichtigt ist. Eine Schräge des Kulissenvorsprungs oder des Magnet-Elements kann einen Winkel zwischen 30° und 60° zur Richtung der Bedienbewegung des Bedienelements aufweisen. Dies hat sich als vorteilhaft und praxistauglich herausgestellt für derartige Bewegungen mit Kulissenvorsprüngen.

An die Schräge kann sich an dem Kulissenvorsprung und/oder an dem zugehörigen Magnet-Element eine im Wesentlichen gerade verlaufende Anlagefläche anschließen. Diese ist vorteilhaft parallel zur Bedienbewegung des Bedienelements und bewirkt keine Lageveränderung des Magnet-Elements mehr bei Relativbewegung zwischen Magnet-Element und Kulissenvorsprung während der Bedienbewegung des Bedienelements. Somit kann nach dem Verändern der Lage des Magnet-Elements aufgrund der Bedienbewegung durch die Schräge während der weiteren Bedienbewegung diese veränderte Lage konstant gehalten werden, um eine erreichte Wirkung auf das magnetochrome Material und somit eine Informationsanzeige beizubehalten. Die Länge dieser Anlagefläche kann variieren und hängt eben davon ab, was als Dauer der entsprechenden Einwirkung auf das magnetochrome Material während der Bedienung mit dem Bedienelement bzw. während der Bewegung des Bedienelements vorgesehen ist.

In vorteilhafter Ausgestaltung der Erfindung kann ein solcher Kulissenvorsprung eine Längsrichtung in einer Ebene parallel zur Bedienbewegung des Bedienelements aufweisen, die parallel zu dieser Bedienbewegung verläuft. Ist die Bedienbewegung also eine Drehung des Bedienelements, so ist die Anlagefläche entsprechend gebogen, abhängig von einem Abstand zu einer Drehachse. Ist die Bedienbewegung ein lineares Verschieben, so ist die Anlagefläche entsprechend gerade ausgebildet.

Vorteilhaft ist pro Magnet-Element mindestens ein Kulissenvorsprung vorgesehen, um dieses bewegen zu können bzw. mindestens einmal bewegen zu können. Es können entlang des Bewegungswegs oder der Bedienbewegung des Bedienelements zwischen seiner Grund-Stellung und einer oder mehreren Bedien-Stellungen auch mehrere Kulissenvorsprünge vorgesehen sein, so dass ein einzelnes Magnet-Element entlang eines maximalen Bewegungswegs des Bedienelements auch mehrfach lageverändert werden kann relativ zum magnetochromen Material, also sozusagen mehrfach eine unterschiedliche optische Wirkung hervorrufen kann.

Ist eine Bewegung des Bedienelements zur Bedienung des Elektrogeräts eine Drehung oder ein Schwenken, so ist es vorteilhaft eine Drehung um eine Drehachse. Dabei können mehrere Magnet-Elemente und die jeweiligen Kulissenvorsprünge um eine Drehachse herum verteilt sein. Die Kulissenvorsprünge können für unterschiedliche Magnet-Elemente entlang von unterschiedlichen Kreisen oder Teilkreisen um die Drehachse herum verlaufen, also mit unterschiedlichem Abstand zur Drehachse. So können sie relativ frei ihre zugehörigen Magnet-Elemente mittels der Kulissen bewegen.

In alternativer Ausgestaltung der Erfindung kann die Bedienbewegung eine vorgenannte lineare Bewegung sein. Dann ist die Kulisse länglich, und die Kulissenvorsprünge sind entlang von parallelen Linien angeordnet, ihr eigener Längsverlauf verläuft dann entlang dieser parallelen Linien.

In nochmals weiterer Ausgestaltung der Erfindung kann vorgesehen sein, dass eine Anordnung von Magneten unter der Bedienblende vorgesehen ist, die also ortsfest sind. Sie können auch die erfindungsgemäßen Magnet-Elemente bilden und somit Teil der Bedieneinrichtung und auch der Halteeinrichtung sein, da das Bedienelement dann an der Bedienblende als Halteeinrichtung gehaltert ist. Das magnetochrome Material ist dann vorteilhaft mit relativ geringem Abstand zu der Bedienblende vorgesehen, so dass ein Abstand zu dieser Anordnung von Magneten darunter nicht zu groß ist. Diese Magnete können ein Halbach-Array bilden mit einer entsprechenden Anordnung von mehreren Dauermagneten, die entsprechend einem solchen Halbach-Array entlang seiner Ausdehnung mit unterschiedlicher Magnetisierungsrichtung versehen sind. Hierzu wird verwiesen auf die DE 10 2016 206 477 A1. Durch diese Ausgestaltung als Halbach-Array kann eine verstärkte Magnetisierung nach oben hin zum magnetochromen Material erfolgen. Möglicherweise können in dem Bedienelement zusätzlich zu dem magnetochromen Material auch wiederum ferromagnetische Teile entsprechend den vorgenannten Magnet-Elementen vorgesehen sein. Diese können das Magnetfeld des Halbach-Arrays nochmals konzentrieren und somit eine gut erkennbare Wirkung auf das magnetochrome Material aufweisen.

Das Halbach-Array kann in weiterer Ausgestaltung der Erfindung so ausgebildet sein, dass es bei einer Drehung des Bedienelements als Bedienbewegung nicht rundsymmetrisch zu einer Drehachse ist. So kann eine abhängig von der Drehung unterschiedliche Beeinflussung des magnetochromen Materials erreicht werden.

Die eingangs genannten Erkennungsmittel, mit denen eine Position bzw. eine Bedienbewegung des Bedienelements erkannt bzw. erfasst werden kann, können vorteilhaft einen Magnetfeldsensor in der Bedieneinrichtung, besonders vorteilhaft unterhalb der Bedienblende, aufweisen. Dieser ist so angeordnet, dass mindestens ein Magnet oder ein Element, das ein Magnetfeld erzeugt oder weiterleitet wie ein eingangs genanntes ferritisches Magnet-Element im Bedienelement, an diesem Magnetfeldsensor vorbeibewegt wird und dies eine Bedienbewegung des Bedienelements genau bestimmen lässt. Bevorzugt sind mindestens zwei dieser Magnetfeldsensoren vorgesehen, was aber aus dem allgemeinen Stand der Technik zu derartigen Bedienelementen bekannt ist, siehe die vorgenannte EP 797 227 A2.

Die Halteeinrichtung kann möglicherweise von der Oberseite des Elektrogeräts bzw. von der Bedienblende abgenommen werden. Sie kann magnetisch gehalten werden durch unterhalb der Bedienblende vorgesehene Magnete, alternativ kann sie mit einem Saugnapf befestigt werden oder durch eine stark haftende gummierte Unterseite.

Bei dem erfindungsgemäßen Verfahren wird also während einer Bewegung des Bedienelements zur Bedienung des Elektrogeräts eine von dieser Bewegung oder von einer Bewegungsstellung bzw. Bedien-Stellung abhängige unterschiedliche Magnetisierung des magnetochromen Materials im Bedienelement vorgenommen. Diese zeigt sich dann eben an der optischen Erscheinung des magnetochromen Materials.

Diese und weitere Merkmale gehen außer aus den Ansprüchen auch aus der Beschreibung und den Zeichnungen hervor, wobei die einzelnen Merkmale jeweils für sich allein oder zu mehreren in Form von Unterkombinationen bei einer Ausführungsform der Erfindung und auf anderen Gebieten verwirklicht sein und vorteilhafte sowie für sich schutzfähige Ausführungen darstellen können, für die hier Schutz beansprucht wird. Die Unterteilung der Anmeldung in Zwischen-Überschriften und einzelne Abschnitte beschränkt die unter diesen gemachten Aussagen nicht in ihrer Allgemeingültigkeit.

### Kurzbeschreibung der Zeichnungen

Ausführungsbeispiele der Erfindung sind in den Zeichnungen schematisch dargestellt und werden im Folgenden näher erläutert. In den Zeichnungen zeigen:
- Fig. 1: eine Seitenansicht einer erfindungsgemäßen Bedieneinrichtung in stark vereinfachter Form an einer Bedienblende,
- Fig. 2: eine schematische Funktionsdarstellung mit einer magnetochromen Folie und einem mit Abstand darunter angeordneten Magnet-Element und rechts daneben dargestellter Informationsanzeige in Draufsicht,
- Fig. 3: die Anordnung aus Fig. 2 mit durch einen Kulissenvorsprung nach oben bewegtem Magnet-Element knapp unterhalb der magnetochromen Folie,
- Fig. 4: eine Explosionsdarstellung einer ersten Ausgestaltung von Bedienelement und Halteeinrichtung,
- Fig. 5: eine zweite leicht abgewandelte Ausgestaltung von Bedienelement und Halteeinrichtung,
- Fig. 6: eine nochmals weitere Abwandlung einer erfindungsgemäßen Ausgestaltung der Halteeinrichtung ohne Bedienelement,
- Fig. 7: eine Draufsicht auf die Magnet-Elemente entsprechend Fig. 6 oberhalb der Kulissenvorsprünge,
- Fig. 8: eine schräge Unteransicht der Magnet-Elemente entsprechend Fig. 6 mit Darstellung der an der Unterseite angeordneten Stößel,
- Fig. 9: eine nochmals weitere Ausgestaltung mit anders ausgebildetem Führungskörper für entlang eines Kreises angeordnete Magnet-Elemente mit Stößeln an der Unterseite,
- Fig. 10: eine Unteransicht auf die Anordnung aus Fig. 9 mit Darstellung einer Betätigungsschnecke, die bei Verdrehen mit einem Schneckenvorsprung die Magnet-Elemente nach oben bewegt und oben hält und
- Fig. 11: die Anordnung aus Fig. 10 mit verdrehter Betätigungsschnecke.

### Detaillierte Beschreibung der Ausführungsbeispiele

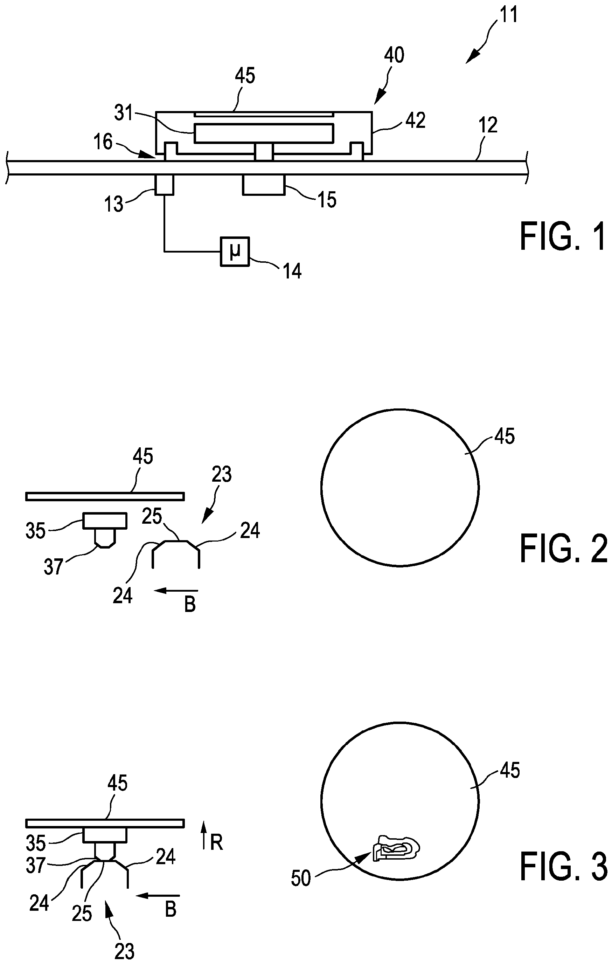

In der Fig. 1 ist eine erfindungsgemäße Bedieneinrichtung 11 vereinfacht von der Seite dargestellt. Die Bedieneinrichtung 11 weist eine Bedienblende 12 auf. Dies kann eine Vorderseite oder Außenseite eines Elektrogeräts sein, alternativ kann es auch eine Kochfeldplatte eines Kochfelds als Elektrogerät sein, welches mit der Bedieneinrichtung 11 bedient werden soll. Dann ist die Bedieneinrichtung 11 sozusagen in das Kochfeld integriert.

Die Bedieneinrichtung 11 weist unterhalb der Bedienblende 12 einen Magnetfeldsensor 13 auf, der mit einer Steuerung 14 zu seiner Auswertung verbunden ist. Des Weiteren ist ein Haltemagnet 15 befestigt. Oberhalb des Haltemagnets 15 ist auf die Oberseite der Bedienblende 12 eine Halteeinrichtung 16 aufgesetzt und wird magnetisch gehalten. Dazu weist die Halteeinrichtung 16 vorteilhaft Gegenmagnete oder ein Eisenteil auf. An der Halteeinrichtung 16 ist ein Bedienelement 40 gehaltert, das einen umlaufenden Bedienring 42 aufweist bzw. zum Großteil von diesem gebildet ist. Dieser Bedienring 42 wird hauptsächlich von der Bedienperson ergriffen und gedreht. Eine Oberseite des Bedienelements 40 weist eine magnetochrome Folie 45 auf, vorteilhaft an bzw. unter einer hier nicht dargestellten Deckscheibe. Unterhalb der magnetochromen Folie 45 ist ein Führungskörper 31 angeordnet mit geringem Abstand darunter, der an der Halteeinrichtung 16 gelagert ist. Das Bedienelement 40 ist gegenüber der Halteeinrichtung 16 drehbar. Bei dieser Drehung wird der Magnetfeldsensor 13 angesprochen oder beeinflusst, beispielsweise durch entsprechende kleine Magnete unten am Außenrand des Bedienelements 40, so dass dessen Drehung erkannt werden kann. Dies ist jedoch allgemein bekannt aus der vorgenannten EP 797 227 A2.

In der Fig. 2 und 3 ist vereinfacht das Funktionsschema der Erfindung dargestellt. Links in Fig. 2 ist ähnlich der Darstellung der Fig. 1 zu ersehen, wie unter einer magnetochromen Folie 45 ein Magnet-Element 35 mit etwas Abstand angeordnet ist, beispielsweise 2 mm bis 5 mm. Unten an dem Magnet-Element 35 ist ein nach links und rechts abgeschrägter Stößel 37 angeordnet bzw. vorgesehen. Das Magnet-Element 35 ist hier ein Dauermagnet, der Stößel 37 kann aus Kunststoff bestehen und angeklebt sein oder sonstwie befestigt sein. Alternativ kann er angeformt sein.

Rechts neben dem Stößel 37 ist ein Kulissenvorsprung 23 dargestellt. Er weist nach links und rechts jeweils eine Schräge 24 auf, dazwischen verläuft an seiner Oberseite eine Auflagefläche 25. Der Kulissenvorsprung 23 wird entsprechend der Bedienungsrichtung B nach links bewegt hin zu dem Magnet-Element 35, alternativ kann die Bewegung in umgekehrter Richtung erfolgen.

Da das Magnet-Element 35 ausreichend Abstand zum magnetochromen Material bzw. zur magnetochromen Folie 45 aufweist, ist an dieser entsprechend der Draufsicht rechts in Fig. 2 nichts zu ersehen. Sie weist normales und unverändertes Aussehen auf.

Ist nun entsprechend Fig. 3 links der Kulissenvorsprung 23 entlang der Bedienungsrichtung B des Bedienelements 40 so gegen den Stößel 37 gefahren, dass der Stößel 37 an der linken Schräge 24 entlang sozusagen nach oben gedrückt worden ist und somit für eine bestimmte Länge eines Bedienwegs entlang der Bedienungsrichtung B an der Auflagefläche 25 oben aufliegt, so ist der Abstand zur magnetochromen Folie 45 erheblich geringer. Möglicherweise kann das Magnet-Element 35 sogar an der Unterseite der magnetochromen Folie 45 anliegen. Dadurch wird das magnetochrome Material in der Folie 45 entsprechend beeinflusst. Bei von oben gesehen länglicher rechteckiger Form des Magnet-Elements 35 ergibt sich dann eine Darstellung entsprechend Fig. 3 rechts, wodurch eine Informationsanzeige 50 gebildet sein kann. Insbesondere wechselt die magnetochrome Folie 45 ihre Farbe in dem dargestellten Bereich, der eben vom Magnetfeld des Magnet-Elements 35 beeinflusst ist. Somit entspricht die Form der Informationsanzeige 50 in etwa der Form des Magnet-Elements 35. Möglicherweise kann hier auch noch eine Beleuchtung oder Durchleuchtung an der magnetochromen Folie 45 vorgesehen sein, um diesen magnetochromen Effekt zu verstärken.

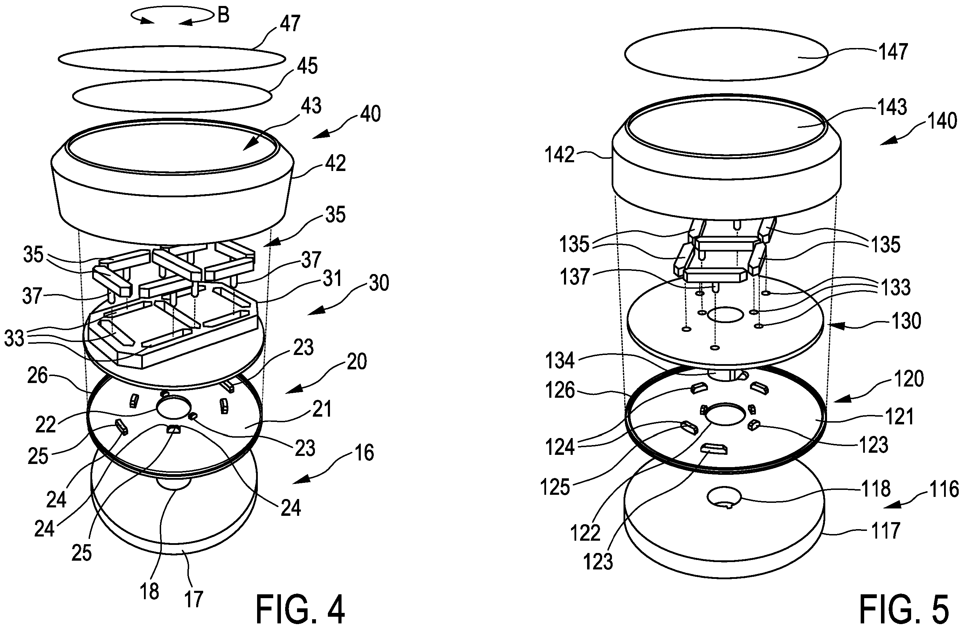

In der Fig. 4 ist in Explosionsdarstellung gezeigt, wie der Teil der Bedieneinrichtung oberhalb der Bedienblende ausgebildet sein kann. Ganz unten ist eine scheibenförmige Bodenplatte 17 vorgesehen mit einer mittigen Ausnehmung 18. Unten in dieser Bodenplatte, die Teil der Halteeinrichtung 16 ist, können vorgenannte Magnete oder Teile aus Eisen vorgesehen sein zum Halten am Haltemagnet 15 unterhalb der Bedienblende 12. In die Ausnehmung 18 kann von oben her ein nicht dargestellter Vorsprung eingreifen, der nachfolgend noch näher erläutert wird. Die Bodenplatte 17 soll sich während einer Bedienung der Bedieneinrichtung 11, welche vorteilhaft eine Drehung ist, nicht bewegen. Grundsätzlich kann sie von der Bedienblende jedoch abgenommen werden, wozu sie eben vorteilhaft magnetisch gehaltert ist.

Auf der Bodenplatte 17 ist eine Kulissenscheibe 20 angeordnet. Die Kulissenscheibe 20 weist einen planen Kulissenscheibenboden 21 auf mit einem mittigen Durchbruch 22. Durch diesen Durchbruch 22 verläuft der vorgenannte Vorsprung. Auf dem Kulissenscheibenboden 21 ist eine Mehrzahl von Kulissenvorsprüngen 23 ausgebildet. Diese weisen jeweils unterschiedlichen Abstand zu einem Mittelpunkt der Kulissenscheibe 20 auf, welcher zentrisch ist zum Durchbruch 22. Die Kulissenvorsprünge 23 weisen jeweils nach links und rechts Schrägen 24 auf, dazwischen verläuft eine Auflagefläche 25. Die Kulissenvorsprünge 23 können unterschiedliche Länge aufweisen, bei den längeren Kulissenvorsprüngen 23 ist zu erkennen, dass sie leicht gebogen verlaufen. Somit ist ihr Verlauf abgerundet entsprechend einem Kreis um den Mittelpunkt der Kulissenscheibe 20 entsprechend einer Drehachse für ein Bedienelement 40. Außen an der Kulissenscheibe 20 ist ein Rand 26 vorgesehen. Dieser Rand 26 kann zur mechanischen Verbindung mit dem Bedienelement 40 vorgesehen sein, da sich die Kulissenscheibe 20 gemeinsam mit dem Bedienelement 40 drehen können soll.

Oberhalb der Kulissenscheibe 20 ist eine scheibenförmige kreisrunde Führungsplatte 30 vorgesehen. An der Unterseite der Führungsplatte 30 ist ein hier nicht dargestellter Vorsprung vorgesehen, der nach unten absteht und sowohl durch den Durchbruch 22 in der Kulissenscheibe 20 verläuft als auch durch oder in die Ausnehmung 18 in der Bodenplatte 17 reicht. Vorteilhaft ist der Vorsprung nicht kreisrund sondern weist eine abstehende Nase odgl. auf, durch welche er drehfest an der Bodenplatte 17 gehalten ist. Dies sollte aber so ausgebildet sein, dass sich die Kulissenscheibe 20 noch um den Vorsprung drehen kann, insbesondere bei ihrer Drehung gelagert ist durch diesen Vorsprung in dem Durchbruch 22.

Die Führungsplatte 30 weist an der Oberseite einen nach oben stehenden Führungskörper 31 auf. Er ist vorteilhaft ein Kunststoffteil mit sieben Kanalführungen 33, die zumindest nach oben offen sind. Leicht erkennbar soll hier eine Art Sieben-Segment-Anzeige realisiert werden. Innerhalb der Kanalführungen 33 sind durchgängige Durchbrüche nach unten vorgesehen.

Die Kanalführungen 33 sind jeweils so ausgebildet, dass darüber angeordnete Magnet-Elemente 35 so passgenau in ihnen gehalten sein können, dass sie leicht nach oben und nach unten bewegt werden können. Dies ist ihre Bewegungsrichtung R, die durch den Pfeil rechts davon verdeutlicht wird. Somit verlaufen auch die Kanalführungen 33 entlang dieser Bewegungsrichtung R. Entlang dieser Richtung R verlaufen auch die an der Unterseite der Magnet-Elemente 35 vorgesehenen Stößel 37, die hier etwas abweichend zu den Fig. 2 und 3 dargestellt sind. Hier sind sie als nach unten ragende Stifte ausgebildet, die an der Unterseite abgerundet sind, um leichter von den Schrägen 24 der Kulissenvorsprünge 23 beim Anlaufen nach oben gedrückt zu werden. Während ihrer Bewegung sollten die Magnet-Elemente 35 stets innerhalb der Kanalführungen 33 bleiben.

Ein Bedienelement 40 mit einem umlaufenden breiten Bedienring 42 übergreift ähnlich Fig. 1 die anderen Funktionseinheiten und ragt im montierten Zustand bis zur Bedienplatte 17 nach unten. Sie ist jedoch nicht fest mit der Bodenplatte 17 verbunden, lediglich mit der Kulissenscheibe 20, damit diese bei Drehung des Bedienelements 40 als Bedienung mit Bedienungsrichtung B im Umlauf mitdrehen kann.

Das Bedienelement 40 weist innerhalb des Bedienrings 42 eine große Ausnehmung 43 auf. In diese wird eine Deckscheibe 47 bündig eingesetzt, vorteilhaft bestehend aus dünnem transparentem Glas. An der Unterseite dieser Deckscheibe 47 ist die magnetochrome Folie 45 vorgesehen, vorteilhaft angeklebt. Alternativ kann eine Unterseite der Deckscheibe 47 auch mit magnetochromem Material beschichtet werden entsprechend einem eingangs genannten und an sich leicht nachvollziehbaren Verfahren. Auch eine Beschichtung der Oberseite der Deckscheibe 47 mit magnetochromem Material wäre möglich. Dann müsste dieses aber mechanisch sehr widerstandsfähig sein. Des Weiteren wäre dann ein minimaler Abstand zu den Magnet-Elementen 35 darunter wiederum vergrößert, was den magnetochromen Effekt wieder ungewünscht abschwächen könnte.

Während sich das Bedienelement 40 mit der Kulissenscheibe 20 dreht auf der Bodenplatte 17, bleibt die überdeckte Führungsplatte 30 zusammen mit der Bodenplatte 17 unbeweglich. So wird eine magnetochrom dargestellte Sieben-Segment-Anzeige nicht mitgedreht, und durch eine solche feststehende Informationsanzeige ist die Bedieneinrichtung intuitiv verständlich für eine Bedienperson.

In der Fig. 5 ist eine Abwandlung der Anordnung aus Fig. 4 dargestellt. Auf einer Bodenplatte 117 mit einer zentralen Ausnehmung 118 ähnlich Fig. 4 ist eine Kulissenscheibe 120 gelagert. Sie weist ebenfalls einen mittigen Durchbruch 122 und mehrere Kulissenvorsprünge 123 auf einem Kulissenscheibenboden 121 auf, die um den Durchbruch 122 herum verteilt sind ähnlich wie in Fig. 4. Die Kulissenvorsprünge 123 sind ausgebildet wie in Fig. 4 und weisen an ihren nach links und rechts weisenden Enden Schrägen 124 auf. Dazwischen weisen sie an der Oberseite eine Auflagefläche 125 auf.

Oberhalb der Kulissenscheibe 120 ist eine Führungsplatte 130 vorgesehen. Diese weist keinen Führungskörper entsprechend Fig. 4 auf, sondern mehrere lochartige Kanalführungen 133. Diese Kanalführungen 133 verlaufen vollständig durch die Führungsplatte 130 hindurch. In sie können Magnet-Elemente 135 mit jeweils an der Unterseite angeordneten Stößeln 137 eingesteckt werden. Um diese gegebenenfalls verdrehsicher zu machen, können alle Magnet-Elemente 135 zwei Stößel aufweisen, wie für das mittlere dargestellt.

Übergriffen werden die genannten Funktionseinheiten hier von einem Bedienelement 140 mit einem Bedienring 142 entsprechend Fig. 4, der eine große Ausnehmung 143 aufweist. Diese wird nach oben geschlossen durch eine Deckscheibe 147, die selbst magnetochromes Material enthält oder aufweist, vorteilhaft an der Unterseite. Die zusätzliche Verwendung einer separaten magnetochromen Folie entfällt also.

Auch hier ist das Bedienelement 140, vorteilhaft an der Innenseite des Bedienrings 142, mit einem Rand 126 der Kulissenscheibe 120 verbunden, und zwar drehfest, so dass sich die beiden Teile gleichmäßig drehen. Abgestützt werden die beiden Teile auf der Oberseite der Bodenplatte 117. Eine Zentrierung während des Drehens als Bedienung erfolgt entweder mittels des Durchbruchs 122 um den Vorsprung 134 herum, zusätzlich oder alternativ dadurch, dass der Bedienring 142 die Bodenplatte 117 übergreift mit geringem Abstand. Diese Bodenplatte 117 samt mittels des Vorsprungs 134 verdrehsicher gehaltener Führungsplatte 130 dreht sich bei Bewegen bzw. Drehen des Bedienelements 140 nicht.

Aus der hier gut erkennbaren Darstellung der Kulissenvorsprünge 123 samt den Magnet-Elementen 135 darüber ist leicht zu ersehen, dass in unterschiedlichen Drehstellungen als Bedien-Stellungen des Bedienelements 140 unterschiedliche Magnet-Elemente 135 als Teil einer Sieben-Segment-Anzeige nach oben bewegt werden können hin zum magnetochromen Material an der Deckscheibe 147. Somit ist es möglich, in verschiedenen Drehstellungen bzw. Bedien-Stellungen des Bedienelements 140 unterschiedliche Ziffern als Informationsanzeige darzustellen oben am Bedienelement 140.

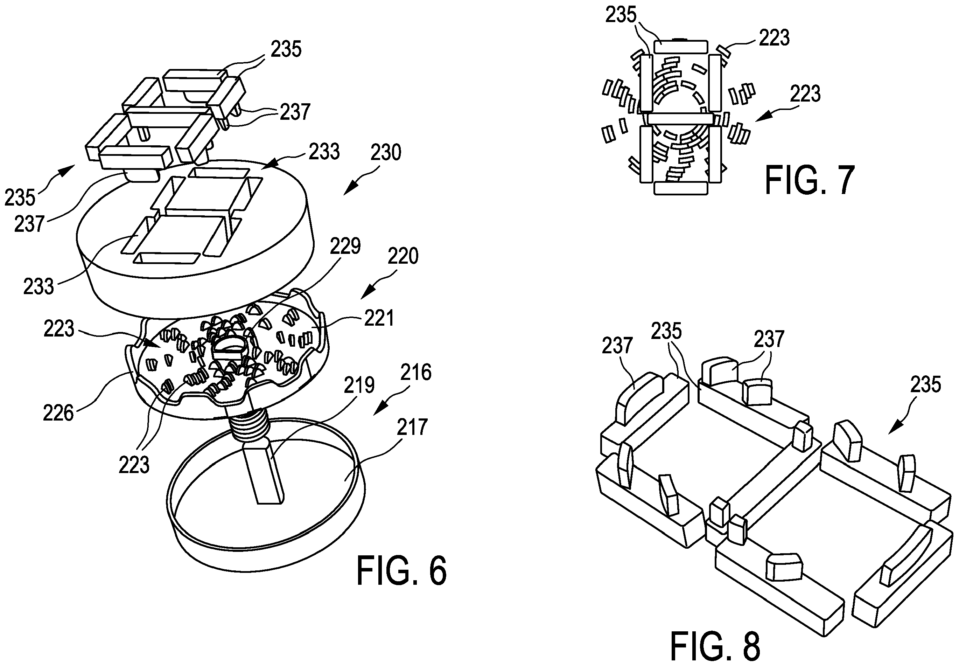

In der Fig. 6 ist eine nochmals weitere Ausgestaltung einer Bedieneinrichtung dargestellt. Eine Bodenplatte 217 weist einen abstehenden Haltezapfen 219 sowie einen umlaufenden hochgezogenen Rand auf. Auf den Haltezapfen 219 ist eine Schraubenfeder aufgesteckt und darauf wiederum eine Kulissenscheibe 220 mit einem breiten, zackig verlaufenden hochgezogenen Rand 226. Mittig in der Kulissenscheibe 220 ist eine dem Profil des Haltezapfens 219 entsprechend ausgebildete Öffnung 229 vorgesehen. Ansonsten sind auf einem Kulissenscheibenboden 221 sehr viele Kulissenvorsprünge 223 vorgesehen. Diese sind relativ kurz, insbesondere sind sie sämtlich identisch ausgebildet und bestehen im Wesentlichen nur aus zwei entgegengesetzten Schrägen 224 ohne vorgenannte Auflagefläche dazwischen. Sie sind auch entlang von Kreisen um einen Mittelpunkt der Kulissenscheibe 220 herum angeordnet.

Oberhalb der Kulissenscheibe 220 ist eine dicke Führungsplatte 230 vorgesehen, die sozusagen gleichzeitig einen Führungskörper entsprechend Fig. 4 bildet. In der Führungsplatte 230 sind sieben Kanalführungen 233 ausgebildet, die entweder ganz hindurchgehen oder sich zumindest von der Oberseite aus ein Stück weit in die Führungsplatte 230 hinein erstrecken. In die Kanalführungen 233 werden Magnet-Elemente 235 hineingesteckt ähnlich wie in Fig. 4, die darin gut geführt sind für eine Bewegung in Bewegungsrichtung R. An der Unterseite der länglichen Magnet-Elemente 235 sind wiederum Stößel 237 vorgesehen, die hier aber nicht stiftartig bzw. kurz ausgebildet sind wie in den Fig. 4 und 5, sondern länglich. Deswegen können die Kulissenvorsprünge 223 auch kürzer ausgebildet sein, was leicht nachvollziehbar ist, da somit die Auflagefläche sozusagen unten an den Stößeln 237 ausgebildet sind.

Über die Anordnung aus Fig. 6 wird dann entsprechend der Fig. 4 und 5 ein passend ausgebildetes Bedienelement aufgesetzt. Anders als zuvor beschrieben ist das Bedienelement dann aber mit der Führungsplatte 230 drehfest verbunden, so dass sich diese mitdreht. Die Kulissenscheibe 220 ist aufgrund der Ausgestaltung der Öffnung 229, die zum Haltezapfen 219 passt, verdrehbar. Wenn die Bodenplatte 217 drehfest an einer Bedienblende vorgesehen ist, beispielsweise nicht abnehmbar befestigt ist, dreht sich bei Drehung des Bedienelements die Führungsplatte 230 mit. Dann rotiert die Informationsanzeige entsprechend einer Sieben-Segment-Anzeige eben.

Aus der Draufsicht der Fig. 7 ist für die Fig. 6 zu erkennen, wie sich die Magnet-Elemente 235 durch die Vielzahl von Kulissenvorsprüngen 223 jeweils in unterschiedlichen Drehstellungen als Bedien-Stellungen des Bedienelements aufgrund der Relativdrehung der Kulissenvorsprünge 223 einerseits und der Magnet-Elemente 235 andererseits nach oben bewegen lassen.

In der Fig. 8 sind die Magnet-Elemente 235 aus Fig. 6 und 7 in Schrägansicht von unten dargestellt. Hier ist gut zu erkennen, dass an der Unterseite jeweils ein oder zwei Stößel 237 vorgesehen sind. Die beiden äußersten Magnet-Elemente 235 weisen nur einen Stößel 237 auf, der dafür länger ausgebildet ist. Die anderen Magnet-Elemente weisen jeweils zwei Stößel 237 auf. Auch sie sind, ähnlich wie zuvor zu Fig. 4 und 5 für die Kulissenvorsprünge beschrieben, leicht gebogen, so dass sie sozusagen genau entlang der gleichen Kreise um eine Drehachse verlaufen wie die Kulissenvorsprünge 233. Die unterschiedliche Länge der Stößel 237 entlang der Bedienrichtung resultiert auch daher, dass sie nicht über die Kontur oder die Außenabmessungen der Magnet-Elemente 235 überstehen. Des Weiteren ist hier auch zu erkennen, dass sie keine Schrägen aufweisen. Diese sind nur an den Kulissenvorsprüngen 223 vorgesehen.

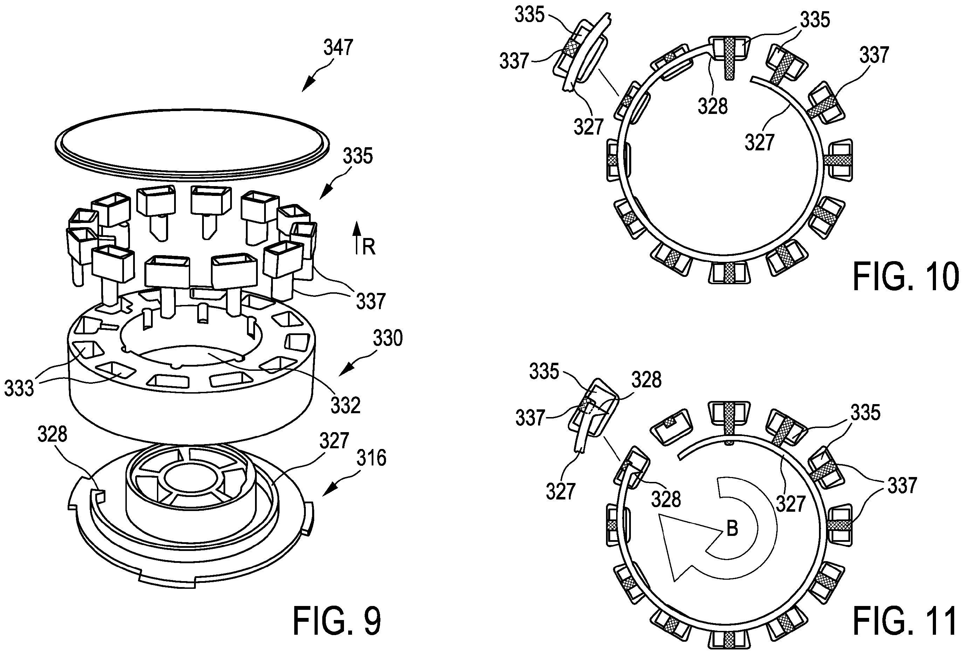

In der Fig. 9 ist ähnlich der Fig. 6 eine nochmals weitere Teilansicht einer erfindungsgemäßen Bedieneinrichtung dargestellt. An einer Kulissenscheibe 320 ist anstelle von Kulissenvorsprüngen eine umlaufende Betätigungsschnecke 327 als eine einzige Kulisse vorgesehen, deren Form aus den Draufsichten der Fig. 10 und 11 besser zu erkennen ist. Sie weist am linken freien Ende einen speziell ausgestalteten Schneckenvorsprung 328 auf. Mittig weist die Kulissenscheibe 320 einen breiten Lagerzapfen auf. Auf diesem ist eine darüber dargestellte Führungsplatte 330 vorgesehen, die ähnlich dick ist wie in der Fig. 6 dargestellt. In der Führungsplatte 330 sind zwölf längliche Kanalführungen 333 vorgesehen, die entlang der Bewegungsrichtung R von oben nach unten hindurch verlaufen. Eine große mittige Öffnung 333 passt genau auf den Lagerzapfen als Drehlager.

In die Kanalführungen 333 werden Magnet-Elemente 335 eingesetzt, welche in Draufsicht trapezartige Form aufweisen. An deren Unterseiten sind Stößel 337 angeordnet, welche jeweils unterschiedliche Form aufweisen. In der Draufsicht der Fig. 10 sind diese Stößel 337 schraffiert dargestellt im Querschnitt. Am obersten Magnet-Element 335 ist dessen Stößel 337 mit der längsten Erstreckung in radialer Richtung versehen. Von dort ausgehend im Uhrzeigersinn wird diese radiale Erstreckung der einzelnen Stößel 337 sozusagen immer kürzer bzw. die Stößel werden sozusagen immer schmaler. Von unten ist in die Führungsplatte 330 ein breiter Schlitz eingefräst, damit sich darin die Betätigungsschnecke 337 drehen kann.

Oberhalb der Magnet-Elemente 335 ist eine Deckscheibe 347 dargestellt, die magnetochromes Material enthält oder als Beschichtung aufweist, vorteilhaft als Beschichtung an der Unterseite der Deckscheibe 347.

Bei dem Bedienelement für diese Ausgestaltung der Erfindung, welches nicht explizit gezeichnet ist, ist die Bedienung wiederum eine Drehung. Aus den Draufsichten der Fig. 10 und 11 ist zu erkennen, dass die Bewegungsrichtung B eine Drehung ist im Uhrzeigersinn. Die Magnet-Elemente 335 bleiben dabei unbewegt, ebenso also auch die Führungsplatte 330. Mit dem Bedienelement dreht sich die Kulissenscheibe 320 samt Betätigungsschnecke 327. Durch Entlanglaufen der Betätigungsschnecke 327 an den Stößeln 337 können diese, abhängig von einer Drehstellung als Bedien-Stellung des Bedien-Elements, samt Magnet-Element 335 nach oben gedrückt werden hin zum magnetochromen Material an der Deckscheibe 347, oder eben nach unten gehen. In der oberen Position bewirken sie eine Darstellung am magnetochromen Material, in der unteren nicht mehr.

Aus der Darstellung der Fig. 9 ist zu erkennen, dass hier für die Magnet-Elemente 335 auch Kunststoffgehäuse vorgesehen sein können aus dünnem Material. An der Unterseite weisen sie integral angeformt die Stößel 337 auf. Von oben weisen sie rechteckige Öffnungen auf, in die rechteckig ausgebildete Dauermagnete als Magnet-Elemente eingesetzt werden können.

In der Fig. 11 ist das Bedienelement um etwas mehr als 300° im Uhrzeigersinn gedreht worden. Wenn die Fig. 10 eine Grund-Stellung darstellt, in der beispielsweise keine Leistung eingestellt werden soll mit der Bedieneinrichtung, so ist durch Drehung im Uhrzeigersinn nach rechts vorgesehen, dass durch das Entlanglaufen des Schneckenvorsprungs 328 an den einzelnen Stößeln 337 jedes zugehörige Magnet-Element 335 nach oben hin zum magnetochromen Material gedrückt wird. Nach einer Drehung von etwa 20° ist nur das oberste Magnet-Element 335 der Fig. 10 nach oben gedrückt, wodurch an dem magnetochromen Material als Informationsanzeige sozusagen nur ein Segment darstellt wird. Wird das Bedienelement dann um etwa 30° weitergedreht, so wird das nächste Magnet-Element nach oben gedrückt und es erscheint ein zweites Segment. Durch die Anzahl dieser Segmente an der Oberseite des Bedienelements, dargestellt durch das farbveränderte magnetochrome Material, kann eine jeweilige Leistungsstufe von 1 bis 12 dargestellt werden. Es werden zwar jeweils unterschiedliche Bereiche des magnetochromen Materials in ihrer Farbe verändert, da es sich über die Magnet-Elemente hinwegdreht, dennoch ist die Informationsanzeige an sich sozusagen nicht verdreht.

## Patentansprüche

1. Bedieneinrichtung (11) für ein Elektrogerät mit:
- einer Bedienblende (12),
- einer Halteeinrichtung (16, 116, 216, 316) an der Bedienblende,
- einem Bedienelement (40, 140), das an der Halteeinrichtung gehaltert ist,
wobei:
- das Bedienelement (40, 140) oder die Halteeinrichtung (16, 116, 216, 316) mindestens ein Magnet-Element (35, 135, 235, 335) mit einem magnetischen Wirkfeld unter einer Oberseite des Bedienelements aufweisen,
- das Bedienelement (40, 140) oberhalb des mindestens einen Magnet-Elements (35, 135, 235, 335) magnetochromes Material (45, 147, 347) an einer Oberseite des Bedienelements sichtbar aufweist derart, dass es zumindest teilweise in der Grund-Stellung und/oder in einer von den Bedien-Stellungen des Bedienelements einer Veränderung des Wirkfelds des Magnet-Elements ausgesetzt ist derart, dass seine optische Erscheinung beeinflusst ist durch das mindestens eine Magnet-Element bzw. durch dessen magnetisches Wirkfeld,
- in der Halteeinrichtung (16, 116, 216, 316) Mittel (20, 23, 24, 37, 120, 123, 124, 137, 220, 223, 237, 327, 337) zur Beeinflussung des magnetochromen Materials (45, 147, 347) durch das Wirkfeld vorgesehen sind, wobei die Mittel derart ausgebildet sind, dass abhängig von einer Bedien-Stellung des Bedienelements (40, 140) an der Halteeinrichtung die optische Erscheinung des magnetochromen Materials beeinflusst ist, **dadurch gekennzeichnet, dass**
- das Bedienelement (40, 140), an der Halteeinrichtung bewegbar ist zwischen einer Grund-Stellung und mehreren Bedien-Stellungen, und
- die Bedieneinrichtung Erkennungsmittel (13, 14) aufweist zur Erkennung einer Position und/ oder Bewegung des Bedienelements (40, 140), um daraus eine Bedienung für das Elektrogerät zu bewirken.

2. Bedieneinrichtung nach Anspruch 1, **dadurch gekennzeichnet, dass** das magnetochrome Material als magnetochrome Folie (45) ausgebildet ist.

3. Bedieneinrichtung nach Anspruch 1 oder 2, **dadurch gekennzeichnet, dass** das magnetochrome Material über oder unter einer lichtdurchlässigen Bedienelementabdeckung (147, 347) an der Oberseite des Bedienelements (41) angeordnet ist, vorzugsweise an einer Unterseite der Bedienelementabdeckung angeordnet ist, wobei insbesondere die Bedienelementabdeckung einen wesentlichen Bereich der Oberseite des Bedienelements bildet.

4. Bedieneinrichtung nach einem der vorhergehenden Ansprüche, **dadurch gekennzeichnet, dass** das mindestens eine Magnet-Element fest und unbewegbar angeordnet ist und das ferromagnetisches Material aufweist, wobei in der Halteeinrichtung oder unter der Bedienblende Magnete angeordnet sind, die abhängig von einer Position des mindestens einen Magnet-Elements über dem Magneten oder daneben das Magnetfeld und somit das Wirkfeld des Magnet-Elements hin zum magnetochromen Material beeinflussen.

5. Bedieneinrichtung nach einem der Ansprüche 1 bis 3, **dadurch gekennzeichnet, dass** das mindestens eine Magnet-Element (35, 135, 235, 335) bewegbar ist relativ zu dem Bedienelement (40, 140) in einer Bewegungsrichtung hin zur Bedienblende (12) oder weg von der Bedienblende, insbesondere mit einer Bewegungsrichtung rechtwinklig zu einer Fläche der Bedienblende, wobei vorzugsweise das mindestens eine Magnet-Element (35, 135, 235, 335) an seiner Oberseite eine Form aufweist, die von einer kreisrunden Form oder rechtwinkligen Form abweicht, wobei insbesondere die Form der Oberseite einer Symbolform auf dem Gebiet des Kochens oder einem Buchstaben oder einer Ziffer entspricht.

6. Bedieneinrichtung nach Anspruch 5, **dadurch gekennzeichnet, dass** mehrere bewegbare Magnet-Elemente (35, 135, 235, 335) vorgesehen sind, wobei vorzugsweise jedes der Magnet-Elemente eine unterschiedliche Form an seiner Oberseite aufweist.

7. Bedieneinrichtung nach Anspruch 5 oder 6, **dadurch gekennzeichnet, dass** die Magnet-Elemente (35, 135, 235, 335) in länglichen Kanälen oder Führungen (33, 133, 233, 333) bewegbar angeordnet sind, wobei die Kanäle oder Führungen entlang der Bewegungsrichtung verlaufen und diese definieren, wobei vorzugsweise die Kanäle oder Führungen mindestens so lang sind wie der Bewegungsweg der Magnet-Elemente.

8. Bedieneinrichtung nach einem der vorhergehenden Ansprüche, **dadurch gekennzeichnet, dass** an der Halteeinrichtung (16, 116, 216, 316) eine Kulisse angeordnet ist mit Kulissenvorsprüngen (23, 123, 223), die nach oben zu dem mindestens einen zugehörigen Magnet-Element (35, 135, 235, 335) hin weisend entlang der Richtung der Bewegung des zugehörigen Magnet-Elements ansteigend mit einer Schräge (124) ausgebildet sind und/oder deren in ihrem Bewegungsweg liegendes zugehöriges Magnet-Element unten mit einer Schräge ausgebildet ist, wobei vorzugsweise pro Magnet-Element (35, 135, 235, 335) mindestens ein Kulissenvorsprung (23, 123, 223) vorgesehen ist entlang einem Bewegungsweg des Bedienelements (40, 140) zwischen der Grund-Stellung und Bedien-Stellungen.

9. Bedieneinrichtung nach einem der vorhergehenden Ansprüche, **dadurch gekennzeichnet, dass** eine Bewegung des Bedienelements (40, 140) eine Drehung um eine Drehachse ist, wobei mehrere Magnet-Elemente (35, 135, 235, 335) und die Kulissenvorsprünge (23, 123, 223) um eine Drehachse herum verteilt sind, wobei vorzugsweise eine feststehende Drehwelle (219) an der Halteeinrichtung (216) angeordnet ist, die nach oben absteht und auf der das Bedienelement drehbar gelagert ist.

10. Bedieneinrichtung nach Anspruch 9, **dadurch gekennzeichnet, dass** die Magnet-Elemente (35, 135, 235, 335) entlang einem Kreis um die Drehachse angeordnet sind, vorzugsweise entsprechend auch die zugehörigen Kulissenvorsprünge(23, 123, 223).

11. Bedieneinrichtung nach einem der vorhergehenden Ansprüche, **dadurch gekennzeichnet, dass** eine Anordnung von Magneten unter der Bedienblende (12) ein außermittiges, nicht zu einer Drehachse des Bedienelements rundsymmetrisches Halbach-Array bildet.

12. Bedieneinrichtung nach einem der vorhergehenden Ansprüche, **dadurch gekennzeichnet, dass** die Halteeinrichtung (16) von der Oberseite der Bedienblende (12) abnehmbar ist, wobei sie vorzugsweise magnetisch an der Bedienblende gehaltert ist.

13. Verfahren zur Bedienung eines Elektrogeräts mit einer Bedieneinrichtung (11) nach einem der vorhergehenden Ansprüche, **dadurch gekennzeichnet, dass** während einer Bewegung des Bedienelements (40, 140) eine von einer Bewegungsstellung abhängige unterschiedliche Magnetisierung des magnetochromen Materials (45, 147, 347) im Bedienelement erfolgt.

14. Verfahren nach Anspruch 13, **dadurch gekennzeichnet, dass** ein oder mehrere Dauermagnete unter der Bedienblende (12) angeordnet sind, wobei die unterschiedliche Magnetisierung des magnetochromen Materials (45, 147, 347) im Bedienelement (40, 140) erfolgt durch Bewegung des magnetochromen Materials über einen oder mehrere der Dauermagnete unter der Bedienblende mit Änderung des Abstands dazu.

15. Verfahren nach Anspruch 13, **dadurch gekennzeichnet, dass** ein oder mehrere Magnete unter der Bedienblende (12) angeordnet sind, wobei die unterschiedliche Magnetisierung des magnetochromen Materials (45, 147, 347) im Bedienelement (40, 140) erfolgt durch Bewegung des Bedienelements mit durch den Magneten unter der Bedienblende bewirkter Bewegung eines Magnet-Elements im Bedienelement mit einer Änderung von dessen Abstand zum magnetochromen Material.

## Claims

1. Operator control device (11) for an electrical appliance with:
- an operator control panel (12),
- a holding device (16, 116, 216, 316) on the operator control panel,
- an operator control element (40, 140) which is secured on the holding device, wherein:
- the operator control element (40, 140) or the holding device (16, 116, 216, 316) has at least one magnet element (35, 135, 235, 335) with a field of magnetic effect under an upper side of the operator control element,
- the operator control element (40, 140) has above the at least one magnet element (35, 135, 235, 335) magnetochromic material (45, 147, 347) visible on an upper side of the operator control element in such a way that it is at least partially subjected to a change of the field of effect of the magnet element in the basic position and/or in one of the operating positions of the operator control element in such a way that its visual appearance is influenced by the at least one magnet element or by the field of magnetic effect thereof,
- in the holding device (16, 116, 216, 316) means (20, 23, 24, 37, 120, 123, 124, 137, 220, 223, 237, 327, 337) for influencing the magnetochromic material (45, 147, 347) by the field of effect are provided, wherein the means are configured in such a way that, depending on an operating position of the operator control element (40, 140) on the holding device, the visual appearance of the magnetochromic material is influenced, **characterized in that**
- the operator control element (40, 140) is movable on the holding device between a basic position and a number of operating positions, and
- the operator control device has detecting means (13, 14) for detecting a position and/or movement of the operator control element (40, 140), in order to cause operation for the electrical appliance.

2. Operator control device according to claim 1, **characterized in that** the magnetochromic material is formed as a magnetochromic film (45).

3. Operator control device according to claim 1 or 2, **characterized in that** the magnetochromic material is arranged over or under a light-transmissive operator control element covering (147, 347) on the upper side of the operator control element (41), preferably on an underside of the operator control element covering, wherein in particular the operator control element covering forms a significant region of the upper side of the operator control element.

4. Operator control device according to any of the preceding claims, **characterized in that** the at least one magnet element is arranged in a fixed and immovable manner and comprises the ferromagnetic material, wherein magnets are arranged in the holding device or under the operator control panel and, depending on a position of the at least one magnet element over the magnet or alongside it, influence the magnetic field, and consequently the field of effect of the magnet element with respect to the magnetochromic material.

5. Operator control device according to any of claims 1 to 3, **characterized in that** the at least one magnet element (35, 135, 235, 335) is movable in relation to the operator control element (40, 140) in a direction of movement towards the operator control panel (12) or away from the operator control panel, in particular with a direction of movement at right angles to a surface area of the operator control panel, wherein preferably the at least one magnet element (35, 135, 235, 335) has on its upper side a form that deviates from a circular form or a rectangular form, wherein in particular the form of the upper side corresponds to the form of a symbol in the area of cooking or a letter or a number.

6. Operator control device according to claim 5, **characterized in that** a number of movable magnet elements (35, 135, 235, 335) are provided, wherein preferably each of the magnet elements has a different form on its upper side.

7. Operator control device according to claim 5 or 6, **characterized in that** the magnet elements (35, 135, 235, 335) are arranged movably in elongated channels or guides (33, 133, 233, 333), wherein the channels or guides run along the direction of movement and define this direction, wherein preferably the channels or guides are at least as long as the path of movement of the magnet elements.

8. Operator control device according to any of the preceding claims, **characterized in that** a slotted link is arranged on the holding device (16, 116, 216, 316) with slotted link projections (23, 123, 223) which, pointing upwards towards the at least one associated magnet element (35, 135, 235, 335), are formed as rising up with a slope (124) along the direction of movement of the associated magnet element and/or their associated magnet element, lying in their path of movement, is formed with a slope at the bottom, wherein preferably for each magnet element (35, 135, 235, 335) at least one slotted link projection (23, 123, 223) is provided along a path of movement of the operator control element (40, 140) between the basic position and operating positions.

9. Operator control device according to any of the preceding claims, **characterized in that** a movement of the operator control element (40, 140) is a turning about an axis of rotation, wherein a number of magnet elements (35, 135, 235, 335) and the slotted link projections (23, 123, 223) are distributed around an axis of rotation, wherein preferably a stationary rotary shaft (219) which protrudes upwards and on which the operator control element is rotatably mounted is arranged on the holding device (216).

10. Operator control device according to claim 9, **characterized in that** the magnet elements (35, 135, 235, 335) are arranged along a circle around the axis of rotation, preferably correspondingly also the associated slotted link projections (23, 123, 223).

11. Operator control device according to any of the preceding claims, **characterized in that** an arrangement of magnets under the operator control panel (12) forms an off-centre Halbach array that is not circularly symmetrical with respect to an axis of rotation of the operator control element.

12. Operator control device according to any of the preceding claims, **characterized in that** the holding device (16) can be removed from the upper side of the operator control panel (12), wherein it is preferably secured magnetically on the operator control panel.

13. Method for operating an electrical appliance with an operator control device (11) according to any of the preceding claims, **characterized in that**, during a movement of the operator control element (40, 140), a different magnetization of the magnetochromic material (45, 147, 347) in the operator control element is performed, depending on a movement position.

14. Method according to claim 13, **characterized in that** one or more permanent magnets are arranged under the operator control panel (12), wherein the different magnetization of the magnetochromic material (45, 147, 347) in the operator control element (40, 140) takes place by movement of the magnetochromic material by way of one or more permanent magnets under the operator control panel by changing the distance from it.

15. Method according to claim 13, **characterized in that** one or more magnets are arranged under the operator control panel (12), wherein the different magnetization of the magnetochromic material (45, 147, 347) in the operator control element (40, 140) takes place by movement of the operator control element with movement of a magnet element in the operator control element brought about by the magnet under the operator control panel by a change of its distance from the magnetochromic material.

## Revendications

1. Dispositif de commande (11) pour un appareil électrique, comprenant :
- un panneau de commande (12),
- un dispositif de retenue (16, 116, 216, 316) sur le panneau de commande,
- un élément de commande (40, 140) retenu sur le dispositif de retenue,
dans lequel :
- l'élément de commande (40, 140) ou le dispositif de retenue (16, 116, 216, 316) présente au moins un élément magnétique (35, 135, 235, 335) avec un champ d'effet magnétique au-dessous d'une face supérieure de l'élément de commande,
- l'élément de commande (40, 140), au-dessus de l'au moins un élément magnétique (35, 135, 235, 335), présente matériau magnétochrome (45, 147, 347) sur une face supérieure de l'élément de commande visible de telle manière qu'il est au moins partiellement dans la position de base et/ou dans une des positions d'opération de l'élément de commande exposé à un changement du champ d'effet de l'élément magnétique de telle manière que son aspect visuel est influencé par l'au moins un élément magnétique ou bien son champ d'effet magnétique,
- dans le dispositif de retenue (16, 116, 216, 316) moyens (20, 23, 24, 37, 120, 123, 124, 137, 220, 223, 237, 327, 337) pour influencer le matériau magnétochrome (45, 147, 347) par le champ d'effet sont prévus, les moyens étant configurés de telle manière que, en fonction d'une position d'opération de l'élément de commande (40, 140), sur le dispositif de retenue l'aspect visuel du matériau magnétochrome est influencé,
**caractérisé en ce que**
- l'élément de commande (40, 140) sur le dispositif de retenue est mobile entre une position de base et plusieurs positions d'opération, et
- l'élément de commande présente moyens de détection (13, 14) pour détecter une position et/ou un mouvement de l'élément de commande (40, 140), afin de provoquer une commande pour l'appareil électrique.

2. Dispositif de commande selon la revendication 1, **caractérisé en ce que** le matériau magnétochrome est sous forme de film magnétochrome (45).

3. Dispositif de commande selon la revendication 1 ou 2, **caractérisé en ce que** le matériau magnétochrome est disposé au-dessus ou au-dessous d'une couverture de l'élément de commande translucide (147, 347) sur la face supérieure de l'élément de commande (41), de préférence disposé sur une face inférieure de la couverture de l'élément de commande, dans lequel en particulier la couverture de l'élément de commande forme une zone importante de la face supérieure de l'élément de commande.

4. Dispositif de commande selon l'une quelconque des revendications précédentes, **caractérisé en ce que** l'au moins un élément magnétique est disposé de manière fixe et immobile et présente matériau ferromagnétique, dans lequel des aimants sont disposés dans le dispositif de retenue ou au-dessous du panneau de commande, lesdits aimants influençant, en fonction d'une position de l'au moins un élément magnétique au-dessus de l'aimant ou à côté, le champ magnétique et ainsi le champ d'effet de l'élément magnétique vers le matériau magnétochrome.

5. Dispositif de commande selon l'une quelconque des revendications 1 à 3, **caractérisé en ce que** l'au moins un élément magnétique (35, 135, 235, 335) est mobile par rapport à l'élément de commande (40, 140) dans une direction de mouvement vers le panneau de commande (12) ou s'éloignant du panneau de commande, en particulier avec une direction de mouvement perpendiculaire à une surface du panneau de commande, dans lequel de préférence l'au moins un élément magnétique (35, 135, 235, 335) sur sa face supérieure présente une forme différente d'une forme circulaire ou forme rectangulaire, dans lequel en particulier la forme de la face supérieure correspond à une forme de symbole dans le domaine de la cuisine ou une lettre ou un chiffre.

6. Dispositif de commande selon la revendication 5, **caractérisé en ce que** plusieurs éléments magnétiques (35, 135, 235, 335) mobiles sont prévus, dans lequel de préférence chacun des éléments magnétiques présente une forme différente sur sa face supérieure.

7. Dispositif de commande selon la revendication 5 ou 6, **caractérisé en ce que** les éléments magnétiques (35, 135, 235, 335) sont agencés de manière mobile dans des canaux ou guidages allongés (33, 133, 233, 333), dans lequel les canaux ou guidages s'étendent le long de la direction de mouvement et en définissant celle-ci, dans lequel de préférence les canaux ou guidages sont au moins aussi longe que le trajet de mouvement des éléments magnétiques.

8. Dispositif de commande selon l'une quelconque des revendications précédentes, **caractérisé en ce que**, sur le dispositif de retenue (16, 116, 216, 316), une coulisse est disposée avec des saillies de coulisse (23, 123, 223), lesdites saillies pointant vers le haut à l'au moins un élément magnétique associé (35, 135, 235, 335) le long de la direction de mouvement de l'élément magnétique associé en montant avec une pente (124) et/ou l'élément magnétique associé se situant dans leur trajet de mouvement présente une pente en dessous, dans lequel de préférence pour chaque élément magnétique (35, 135, 235, 335) au moins une saillie de coulisse (23, 123, 223) est prévue le long d'un trajet de mouvement de l'élément de commande (40, 140) entre la position de base et des positions d'opération.

9. Dispositif de commande selon l'une quelconque des revendications précédentes, **caractérisé en ce qu'**un mouvement de l'élément de commande (40, 140) est une rotation autour d'un axe de rotation, dans lequel plusieurs éléments magnétiques (35, 135, 235, 335) et les saillies de coulisse (23, 123, 223) sont réparties autour d'un axe de rotation, dans lequel de préférence un arbre rotatif (219) fixe est disposé sur le dispositif de retenue (216), ledit arbre faisant saillie vers le haut et sur ledit arbre l'élément de commande est logé de manière tournante.

10. Dispositif de commande selon la revendication 9, **caractérisé en ce que** les éléments magnétiques (35, 135, 235, 335) sont disposés le long d'un cercle autour de l'axe de rotation, de préférence aussi correspondant à les saillies de coulisse (23, 123, 223) associées.

11. Dispositif de commande selon l'une quelconque des revendications précédentes, **caractérisé en ce qu'**un arrangement d'aimants au-dessous du panneau de commande (12) forme un réseau de Halbach excentrique, pas à symétrie circulaire par rapport à un axe de rotation de l'élément de commande.

12. Dispositif de commande selon l'une quelconque des revendications précédentes, **caractérisé en ce que** le dispositif de retenue (16) est amovible de la face supérieure du panneau de commande (12), dans lequel de préférence ledit dispositif de retenue est supporté magnétiquement sur le panneau de commande.

13. Procédé de fonctionnement d'un appareil électrique par un dispositif de commande (11) selon l'une quelconque des revendications précédentes, **caractérisé en ce que**, pendant un mouvement de l'élément de commande (40, 140), une magnétisation différente du matériau magnétochrome (45, 147, 347) dans l'élément de commande se produit en fonction d'une position de mouvement.

14. Procédé selon la revendication 13, **caractérisé en ce qu'**un aimant permanent ou plusieurs aimants permanents sont disposés au-dessous du panneau de commande (12), dans lequel la magnétisation différente du matériau magnétochrome (45, 147, 347) dans l'élément de commande (40, 140) se produit par mouvement du matériau magnétochrome à travers l'un aimant permanent ou les plusieurs aimants permanents au-dessous du panneau de commande en modifiant la distance de celui-ci.

15. Procédé selon la revendication 13, **caractérisé en ce qu'**un aimant ou plusieurs aimants sont disposés au-dessous du panneau de commande (12), dans lequel la magnétisation différente du matériau magnétochrome (45, 147, 347) dans l'élément de commande (40, 140) se produit par mouvement de l'élément de commande avec un mouvement d'un élément magnétique dans l'élément de commande provoqué par l'aimant au-dessous du panneau de commande présentant une modification de la distance dudit élément du matériau magnétochrome.
